# FASCICULE DE BREVET EUROPEEN

(11) **EP 2 442 353 B1**
(45) Date de publication et mention de la délivrance du brevet: **01.01.2020**
(21) Numéro de dépôt: 11184093.0
(22) Date de dépôt: 06.10.2011
(51) Int. Cl.: H01L 21/67

(54) **PROCÉDÉ DE COLLAGE MOLÉCULAIRE DE SUBSTRATS EN SILICIUM ET EN VERRE**
VERFAHREN ZUR MOLEKULAREN VERBINDUNG VON SILIZIUM- UND GLASS-SUBSTRATEN
PROCESS FOR MOLECULAR BONDING OF A SILICON TO A GLASS SUBSTRATE.

(30) Priorité: 12.10.2010 FR 1058299
(43) Date de publication de la demande: 18.04.2012
(73) Titulaire: Soitec, 38190 Bernin (FR)
(72) Inventeur: Delprat, Daniel, 38920 CROLLES (FR); Kerdiles, Sébastien, 38330 SAINT-ISMIER (FR)
(74) Mandataire: Regimbeau

(56) Documents cités:
- WO-A2-2007/047536
- WO-A2-2009/135800
- US-A- 5 273 553
- US-A1- 2003 010 275
- US-E- R E36 890

## Description

### Domaine de l'invention

Le domaine de la présente invention est celui des structures de silicium sur verre (SiOG, pour « Silicon-On-Glass »).

Plus précisément, l'invention concerne un procédé amélioré pour réaliser cette structure.

### Contexte de l'invention

La technologie du silicium sur isolant (SOI, pour « Silicon-On-Insulator ») est de plus en plus importante pour obtenir des transistors à couches minces, des cellules solaires, etc. très performants. Les tranches semi-conductrices (appelées « wafers ») de SOI consistent en une fine couche de silicium sensiblement monocristallin (généralement inférieure à un micron) sur un matériau isolant.

Diverses structures et diverses manières d'obtenir ces wafers sont connues. Généralement, les structures utilisées sont formées par une couche mince de silicium collée à un autre wafer de silicium avec une couche isolante d'oxyde entre elles.

Du fait de son épaisseur assez importante, en particulier comparée aux autres parties, une fraction majeure du coût de ces structures était le coût du substrat en silicium qui supporte la couche d'oxyde, recouverte par la mince couche de silicium. Ainsi, pour diminuer le coût des structures SOI, l'utilisation d'un substrat support réalisé en des matériaux moins coûteux que le silicium a été tentée, en particulier le verre ou les vitrocéramiques.

Les structures SOI utilisant ces substrats à base de verre sont appelées structures SiOG, comme déjà mentionné. Des processus pour réaliser une structure SiOG sont décrits, par exemple, dans le brevet US n° 7 176 528. Un tel processus est représenté par la figure 1. Des espèces ioniques telles que l'hydrogène sont implantées dans un substrat source 1b, généralement réalisé en silicium. L'implantation mène à la création d'une zone 7 affaiblie enfouie. En outre, le substrat source 1b est collé à un substrat support à base de verre la et ensuite séparé en divisant le substrat source 1b à une profondeur correspondant à la profondeur de pénétration des espèces implantées. De cette manière, sont produits une structure SiOG contenant le substrat support à base de verre la d'origine et une couche 8 du substrat source 1b, et un substrat délamifié restant qui est une partie de l'ancien substrat source 1b.

Cependant, il n'est pas simple de remplacer un substrat support SOI classique par un substrat support à base de verre. Un problème potentiel lié au SiOG est que le substrat support à base de verre la contient généralement des métaux (en particulier des alcalis) et d'autres composants qui peuvent être nuisibles pour le silicium ou pour d'autres matériaux semi-conducteurs de la couche 8 du substrat source 1b. Par conséquent, une couche protectrice est généralement nécessaire entre le substrat support à base de verre la et le substrat source 1b. De plus, cette couche protectrice peut faciliter l'adhérence entre la couche de silicium 8 et le substrat support à base de verre la en rendant la surface de collage de la couche de silicium 8 hydrophile. A cet égard, une couche de SiO₂ peut être utilisée en tant que couche protectrice pour obtenir des conditions de surface hydrophile entre le substrat support à base de verre la et la couche de silicium 8.

Une couche de SiO₂ native peut être directement formée sur un substrat source en silicium 1b en l'exposant à l'atmosphère avant le collage. Alternativement, lorsqu'un collage anodique est utilisé, le processus de collage anodique produit « in situ » une couche de SiO₂ entre le substrat source en silicium 1b et le substrat support à base de verre la. Autrement, une couche de SiO₂ peut être déposée ou développée activement sur le substrat source 1b avant le collage.

Le brevet US 5273553 décrit un appareil pour lier des substrats semi-conducteurs, l'appareil comprenant: un premier moyen de maintien pour gauchir et maintenir un premier et un second substrats semi-conducteurs.

Le brevet US 7 176 528 présente un autre type de couche protectrice qui peut être réalisée par un processus de collage anodique, cette couche protectrice étant une couche supérieure modifiée de verre du substrat support à base de verre la avec un niveau réduit d'ions. Le collage anodique présenté élimine sensiblement d'une couche supérieure d'épaisseur environ 100 nm du substrat à base de verre les constituants alcalins et alcalino-terreux du verre, et les autres ions modificateurs positifs qui sont nuisibles pour le silicium.

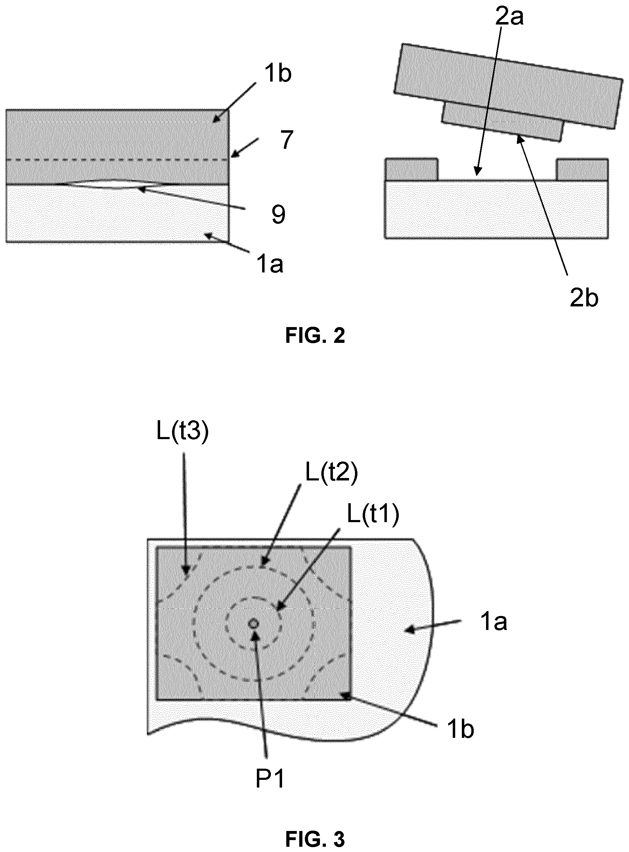

Un collage moléculaire est ensuite habituellement réalisé en mettant les deux surfaces des substrats en quasi-contact. Une pression est appliquée aux substrats au moyen d'un piston mécanique afin de rapprocher localement les deux surfaces à une distance nanométrique. Dans le cas d'un collage hydrophile, cela conduit à l'établissement de collages hydrogène entre les molécules d'eau adsorbées au niveau des deux surfaces hydrophiles. Avec l'établissement progressif de collages hydrogène aux bords de la zone déjà collée, la zone collée augmente graduellement. Une onde de collage se propage ainsi jusqu'à ce qu'elle atteigne le bord d'au moins l'un des substrats. Toute perturbation de la propagation de l'onde de collage ou de la fermeture de l'onde de collage au bord d'un substrat peut conduire au piégeage d'une bulle d'air 9. Ces bulles d'air 9 empêchent localement le collage des substrats, ce qui crée des trous dans la couche 8 séparée du substrat source 1b et collée au substrat support à base de verre la, comme représenté sur la figure 2.

Il existe, par conséquent, un besoin pour un procédé pour coller les deux substrats qui évite que des bulles soient piégées pendant le collage moléculaire.

### Résumé de l'invention

L'objet de la présente invention consiste à proposer des substrats de haute qualité en silicium et verre collés exempts de bulle. De plus, la présente invention a également pour objet de réaliser un collage efficace de séries de substrats, afin d'accélérer les processus industriels et de réduire les coûts.

A ces fins, la présente invention propose un procédé pour coller un premier substrat (la) comportant une première surface à une pluralité de deuxième substrats comportant chacun une deuxième surface, caractérisé en ce qu'il comprend les étapes consistant à :- maintenir le premier substrat (la) par au moins deux points de support (SI, S2),-positionner le premier substrat (la) et les deuxièmes substrats de sorte que la première surface et les deuxièmes surfaces soient l'une en face des autres,- déformer le premier substrat (la) entier en appliquant, entre au moins un point de pression (P1) et les deux points de support (SI, S2), une contrainte (F) dirigée vers les deuxièmes substrats,- amener la première surface déformée et au moins une deuxième surface en contact,- relâcher progressivement la contrainte (F), le premier substrat (la) étant collé simultanément à ladite pluralité de deuxièmes substrats.

Les caractéristiques préférées mais non limitatives de la présente invention sont comme suit :
- l'aire de l'enveloppe convexe formée par l'ensemble des points de pression est nulle et l'aire de l'enveloppe convexe formée par l'ensemble des points de support et de pression n'est pas nulle ;
- le premier substrat est maintenu par des ventouses placées au niveau des points de support ;
- chaque ventouse est reliée à un bras télescopique ;
- les deuxièmes substrats sont placés sur un support comprenant au moins deux éléments d'espacement respectivement de chaque côté des deuxièmes substrats, lesdits éléments d'espacement étant plus hauts que l'épaisseur des deuxièmes substrats;
- le premier substrat est maintenu en reposant sur les éléments d'espacement, les points de support étant des points de contact entre les éléments d'espacement et le premier substrat ;
- le support comprend au moins une ventouse maintenant les deuxièmes substrats ;
- la contrainte est appliquée par au moins une tige de piston ;
- le premier substrat est une feuille de verre, et dans lequel les deuxièmes substrats sont en tuile de silicium.

### Brève description des dessins

Les objets, caractéristiques et avantages ci-dessus et d'autres de la présente invention seront évidents dans la description détaillée qui suit d'un mode de réalisation illustratif de celle-ci, qui doit être lue en relation avec les dessins joints, sur lesquels :

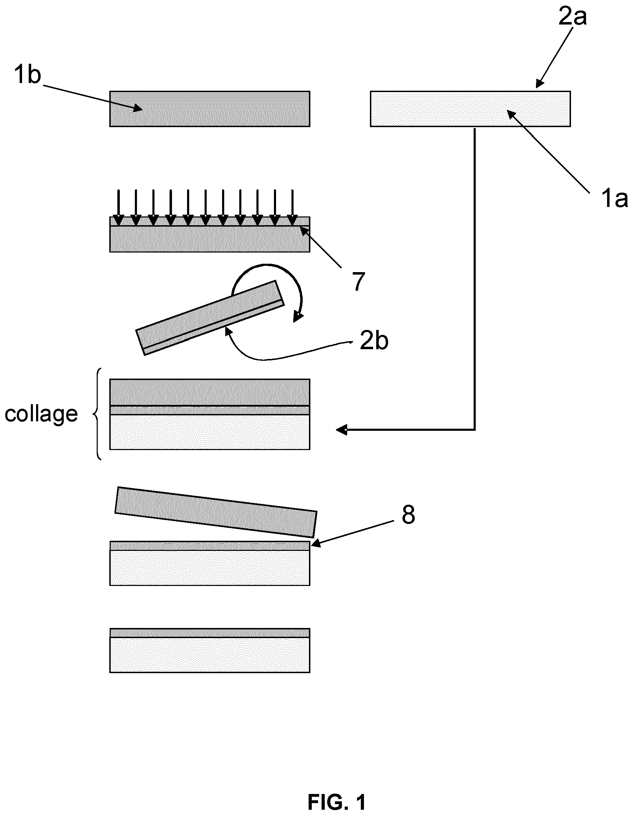

- la figure 1 décrite précédemment représente les étapes d'un processus connu pour réaliser des structures SiOG ;
- la figure 2 décrite précédemment est une vue transversale d'un détail d'un défaut causé par la présence d'une bulle dans une structure SOI ;
- la figure 3 représente une onde de propagation de collage pendant une collage moléculaire ;
- la figure 4 représente un mode de réalisation d'une étape de maintien d'un substrat dans un processus selon l'invention ;
- les figures 5a à 5c représentent un autre mode de réalisation d'une étape de maintien d'un substrat dans un processus selon l'invention ;

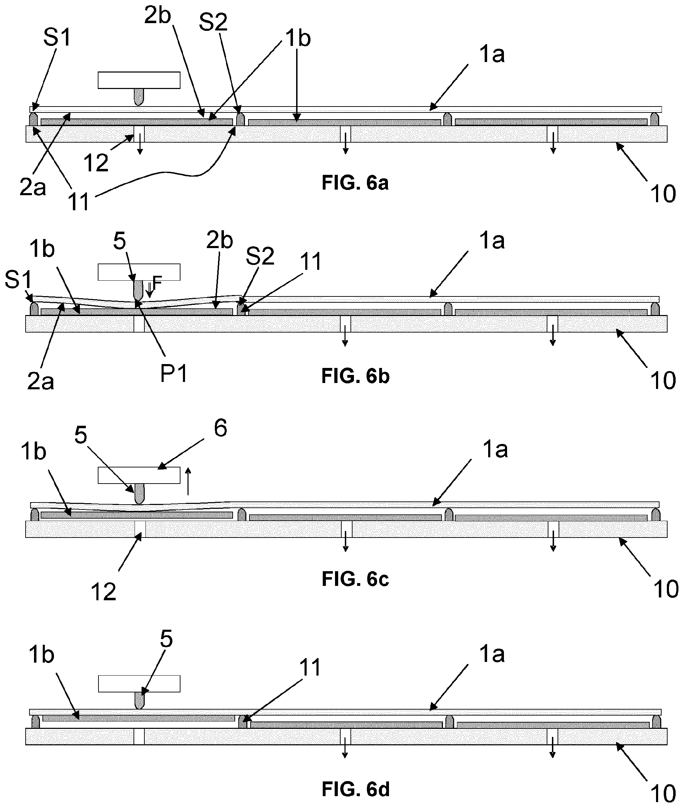

- les figures 6a à 6d représentent les étapes successives d'un mode de réalisation d'un processus qui ne fait pas partie de l'invention telle que revendiquée ;

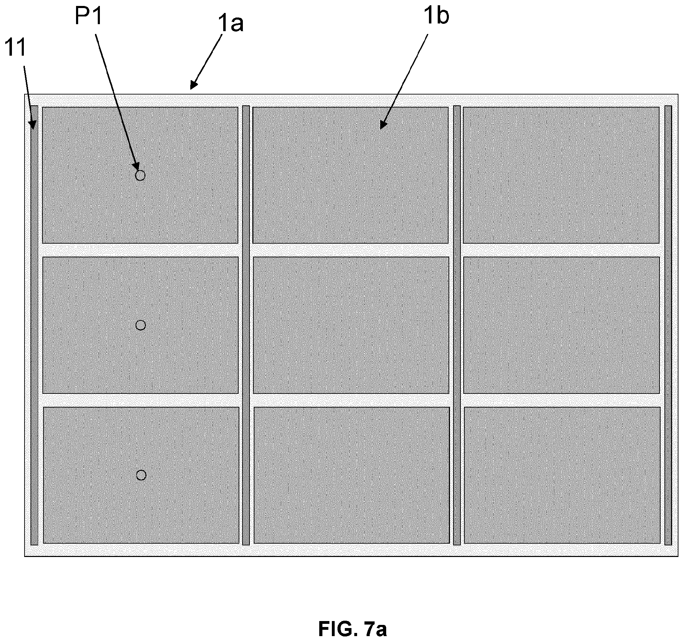

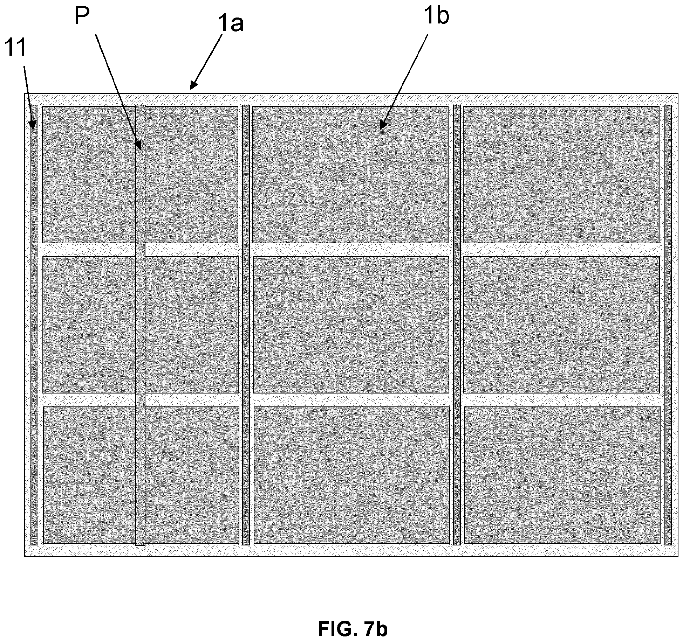

- les figures 7a à 7b sont des vues de dessus d'autres dispositions possibles de substrats sur un support dans un mode de réalisation d'un processus selon l'invention ;
- les figures 8a à 8f représentent les étapes successives d'un mode de réalisation d'un processus selon l'invention.

### Description détaillée d'un mode de réalisation préféré

Avec référence aux dessins, un procédé selon un mode de réalisation possible de l'invention va maintenant être décrit.

Pour éviter le piégeage de bulles, la seule solution est de contrôler soigneusement la propagation de l'onde de collage, telle que représentée sur la figure 3. En effet, le front d'onde de collage est la courbe délimitant à un instant donné la zone déjà collée (c'est-à-dire, déjà parcourue par l'onde de collage), et s'étendant vers les zones non liées par attraction moléculaire. Une bulle est piégée si deux points distincts de cette courbe se joignent, entourant de ce fait une zone non liée. Etant donné que l'air ne peut pas s'échapper d'une telle zone entourée non liée, le front d'onde de collage s'arrête. Ainsi, à tout moment, le front d'onde de collage doit être continu.

Dans le cas représenté, la collage commence par un contact au point P1. Ensuite, le front d'onde de collage s'étend radialement : L(t1), L(t2) et L(t3) représentent la position du front d'onde de collage à trois instants t1 < t2 < t3. A partir du lancement de la collage centrale, le front d'onde de collage s'étend jusqu'aux bords du deuxième substrat 1b, expulsant l'air sans le piéger.

Dans ce contexte, l'invention propose un procédé pour coller un premier substrat la comportant une première surface 2a à un deuxième substrat 1b comportant une deuxième surface 2b, dans lequel la propagation de l'onde de collage est contrôlée. Le premier substrat la est maintenu par au moins deux points de support S1 et S2, positionné à proximité (par exemple, 100 à 1 000 microns) du deuxième substrat 1b de sorte que la première surface 2a et la deuxième surface 2b soient l'une en face de l'autre. Le premier substrat est déformé afin d'avoir un contact unique entre les deux surfaces 2a et 2b. Cette déformation est obtenue en appliquant, entre au moins un point de pression P1 différent des deux points de support S1 et S2, une contrainte F dirigée vers le deuxième substrat 1b et en amenant ensuite la première surface 2a déformée et la deuxième surface 2b en contact. La déformation peut être effectuée jusqu'à ce que la première surface 2a déformée et la deuxième surface 2b soient en contact, ou, en variante, le premier substrat la peut être déformé, et ensuite sa première surface la peut être amenée en contact avec la deuxième surface 2a par translation une fois que la déformation est achevée. A partir de ce contact, qui est situé au point de pression P1, l'onde de collage est lancée. La déformation du premier substrat la est d'environ quelques centaines de microns, ce qui est très faible comparé aux dimensions latérales des substrats généralement utilisés, c'est-à-dire quelques centaines de millimètres. Par exemple, la force nécessaire pour obtenir une déformation de 200 microns au milieu d'un substrat en silicium d'une épaisseur de 775 microns ayant une surface de 20 cm x 20 cm et supporté au niveau de ses bords est d'environ 1,3 N, et la force nécessaire pour obtenir une déformation de 200 microns au milieu d'un substrat en silicium d'une épaisseur de 500 microns ayant une surface de 20 cm x 20 cm et supporté au niveau de ses bords est d'environ 0,2 N.

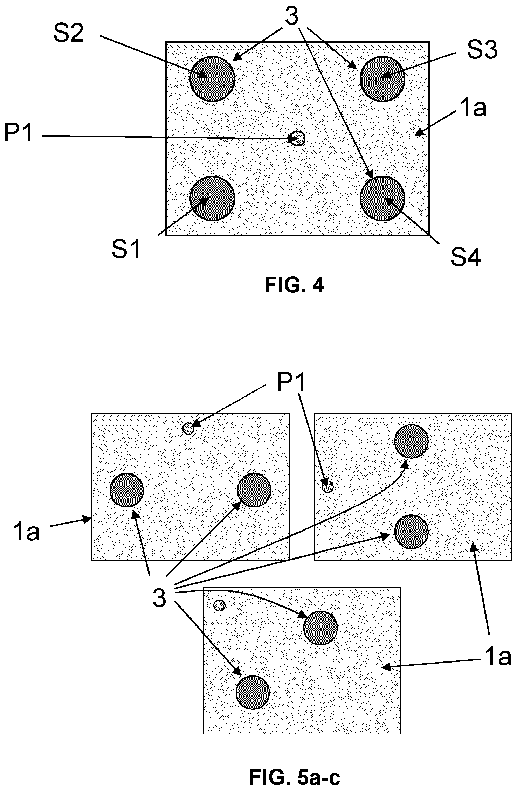

Un premier mode de réalisation est représenté sur la figure 4. Dans ce mode de réalisation avantageux, le premier substrat la est maintenu en quatre points de support S1, S2, S3 et S4 par un système sous vide, une ventouse 3 étant placée au niveau de chaque point de support. Le premier substrat la est ensuite positionné à quelques dixièmes de millimètres au-dessus du deuxième substrat.

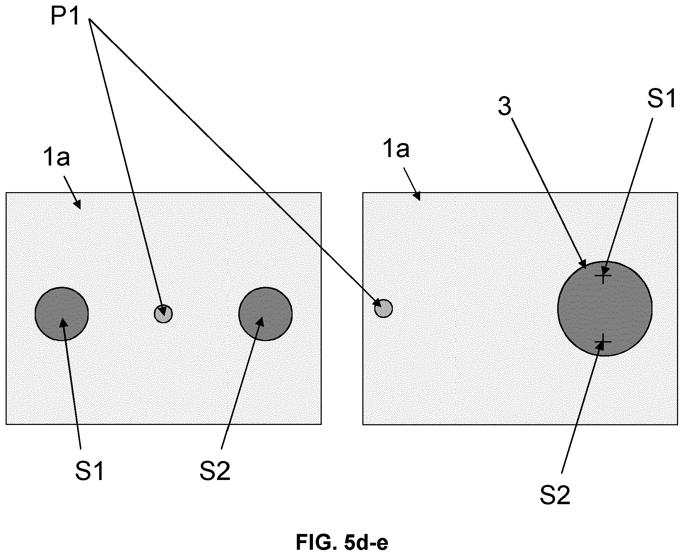

Les figures 5a à 5c montrent d'autres géométries pour les points de support et de pression qui permettent le lancement de la propagation de l'onde de collage à différents emplacements. Deux points de support seulement sont nécessaires. L'invention n'est pas limitée à l'une quelconque de ces géométries, et un homme du métier saurait comment placer les points de support et de pression en fonction de la forme et du matériau du premier substrat la.

La géométrie des points de support et de pression peut, par exemple, respecter deux conditions :
- Au moins deux points de support S1 et S2 doivent être non alignés avec au moins un point de pression P1. Autrement dit, l'enveloppe convexe formée par l'ensemble des points de support et de pression (c'est-à-dire, le polygone le plus petit contenant au moins chaque point de cet ensemble) doit avoir une aire non nulle. Cependant, il n'existe aucun moyen de support physique qui soit totalement ponctuel : par exemple, une ventouse 3 s'étend sur plusieurs cm². Ainsi, si les ventouses 3 sont suffisamment grandes, les géométries telles que représentées par les figures 5d à 5e ne contredisent pas cette première condition et peuvent être utilisées dans un mode de réalisation du procédé selon l'invention, étant donné qu'une ventouse 3 agit en tant que pluralité de points de support suffisamment éloignés.
- S'il y a au moins trois points de pression, ils ne doivent pas former un triangle. Autrement dit, l'enveloppe convexe formée par l'ensemble des points de pression doit avoir une aire de surface nulle. Si un triangle est formé, lorsqu'un contact entre les surfaces 2a et 2b est réalisé, le front d'onde de collage lie les bords du triangle, et de l'air peut être piégé à l'intérieur. Au contraire, si tous les points de pression forment une ligne, aucune zone dans laquelle l'air peut être piégé n'apparaît.

Le premier substrat la est ensuite cintré en appliquant la contrainte F entre ledit au moins un point de pression P1 et les points de support, par exemple grâce au déplacement d'une tige de piston 5 en contact avec le premier substrat la au point de pression P1. En outre, le contact entre la tige de piston 5 et le premier substrat la peut être linéaire et non ponctuel, selon la deuxième condition expliquée ci-dessus. Dans ce cas, la contrainte F est appliquée entre les points de support (S1, S2) et une ligne de pression P. Lorsque les deux surfaces 2a et 2b sont en contact, le collage moléculaire est lancé.

La dernière étape consiste à relâcher la contrainte F pour laisser l'onde de collage se propager.

Une première possibilité considérée consiste simplement à relâcher le vide d'un seul coup et de provoquer une propagation à grande vitesse de l'onde de collage. Cependant, le demandeur a remarqué que cette propagation est plus rapide au niveau du bord du substrat qu'ailleurs. Ainsi, les parties latérales du front d'onde de collage pourraient se rejoindre alors que la partie centrale n'a pas encore atteint le bord du substrat. Cela pourrait entraîner le piégeage d'une bulle.

Pour éviter ce risque, la solution proposée par l'invention consiste à relâcher progressivement, et non soudainement, la contrainte F appliquée entre les points de support et de pression (S1, S2, Pl...), afin de contrôler à tout moment la propagation de l'onde de collage. A cette fin, les ventouses 3 peuvent être montées, par exemple, sur des bras télescopiques 4.

De façon avantageuse, dans une variante du procédé selon l'invention, le premier substrat la est collé à une pluralité de deuxièmes substrats 1b. En effet, le premier substrat la est, par exemple, une feuille de verre, alors que le deuxième substrat 1b est une tuile de silicium. De grandes feuilles de verre peuvent être facilement fabriquées, de sorte qu'elles puissent recevoir une pluralité de substrats en silicium, étant donné que lesdits substrats ont généralement une largeur entre 20 et 30 cm. Cependant, l'invention n'est pas limitée au collage de substrats de verre et de silicium.

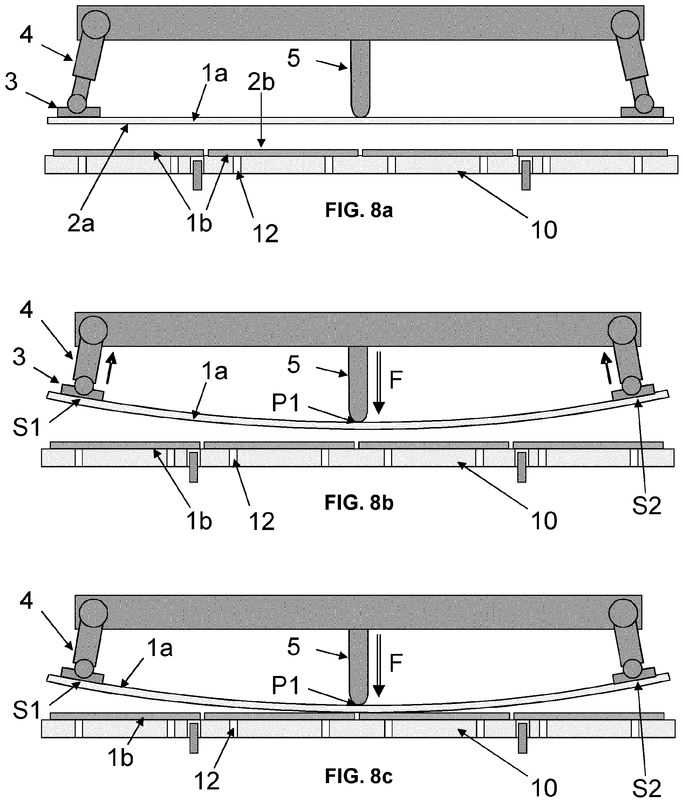

Selon un mode de réalisation avantageux de l'invention, le premier substrat la entier est déformé, et il est collé simultanément à la pluralité de deuxièmes substrats 1b. Dans ce cas, comme on peut le voir sur la figure 8a, la séquence de collage commence par une étape de positionnement préalable des substrats. Le premier substrat la est maintenu sous vide par des ventouses 3 à l'extrémité de bras télescopique 4 au-dessus d'une pluralité de deuxièmes substrats 1b qui reposent sur le support 10. Chaque deuxième substrat 1b peut être maintenu par au moins une ventouse 12 logée dans le support 10. Le centre de la première surface 2a du substrat la est maintenu à au moins 100 µm au-dessus des surfaces 2b des deuxièmes substrats 1b.

Pour déformer ce substrat la, un élément central, par exemple une tige de piston 5, est en contact avec le substrat la au point P1. Les ventouses 3 et les bras télescopiques 4 sont mobiles en rotation de sorte que le substrat la peut prendre une forme libre, imposée seulement par les points S1 et S2 de contact entre le substrat la et les ventouses 3, et le point P1 de contact avec la tête de la tige de piston 5. En allongeant la tige de piston 5, la contrainte F est appliquée et le point P1 se rapproche des substrats 1b, comme représenté par la figure 8b.

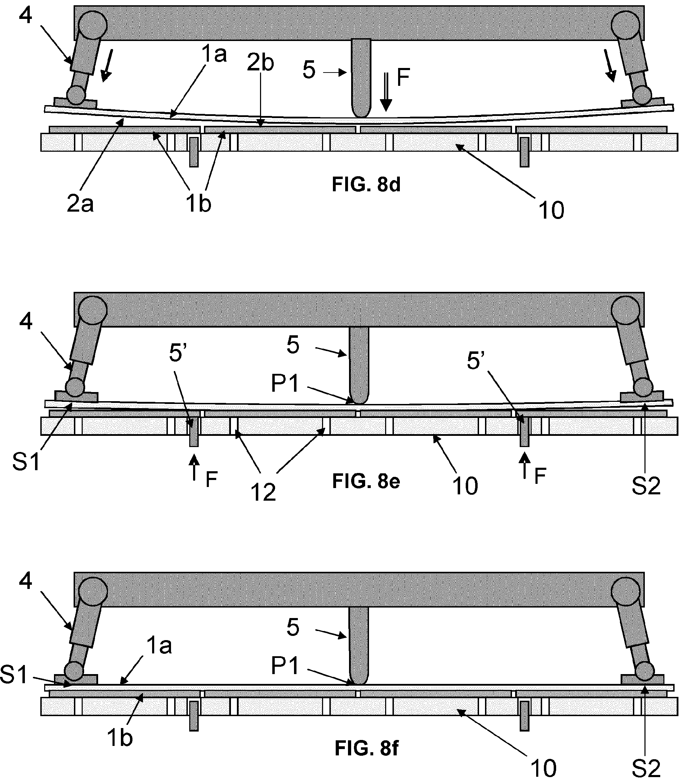

Une force de contact inférieure à 10 N (par exemple, de 2 à 10 N) est appliquée pour commencer le collage moléculaire (figure 8c). L'onde de propagation de collage est ensuite lancée par un relâchement graduel du cintrage imposé sur le premier substrat la. Pour cela, les bras télescopiques sont allongés (figure 8d). La vitesse de ce relâchement est limitée de sorte qu'un front d'onde de collage uniforme se propage entre les deux substrats la et 1b.

Lorsque le front d'onde de collage atteint d'autres deuxièmes substrats 1b, comme représenté par la figure 8e, avantageusement, des tiges de piston auxiliaires 5' logées dans la structure 10 lancent des ondes de collage sur les autres deuxièmes substrats 1b. La séquence de collage se termine lorsque les contraintes appliquées au premier substrat la entier sont relâchées (figure 8f).

En particulier, il est important de distinguer deux cas selon que le nombre de rangées de deuxièmes substrats 1b est impair ou pair. Si ce nombre est pair (comme montré sur la figure 8), le premier contact est effectué sur le bord des deux rangées centrales. Si ce nombre est impair, le premier contact est au centre de la rangée centrale. Le mécanisme de collage est le même pour les rangées latérales.

Ce mode de réalisation du procédé selon l'invention permet un processus industriel à grande vitesse, étant donné qu'une pluralité de tuiles de silicium peuvent être collées en une fois. De plus, étant donné qu'un petit nombre seulement de manipulations sont nécessaires, un tel procédé garantit un collage très précis conduisant à des produits de qualité élevée.

## Revendications

1. Procédé pour coller un premier substrat (1a) comportant une première surface (2a) à une pluralité de deuxième substrats (1b) comportant chacun une deuxième surface (2b), **caractérisé en ce qu'**il comprend les étapes consistant à :
- maintenir le premier substrat (1a) par au moins deux points de support (S1, S2),
- positionner le premier substrat (1a) et les deuxièmes substrats (1b) de sorte que la première surface (2a) et les deuxièmes surfaces (2b) soient l'une en face des autres,
- déformer le premier substrat (1a) entier en appliquant, entre au moins un point de pression (P1) et les deux points de support (S1, S2), une contrainte (F) dirigée vers les deuxièmes substrats (1b),
- amener la première surface (2a) déformée et au moins une deuxième surface (2b) en contact,
- relâcher progressivement la contrainte (F), le premier substrat (1a) étant collé simultanément à ladite pluralité de deuxièmes substrats (1b).

2. Procédé selon la revendication 1, dans lequel l'aire de l'enveloppe convexe formée par l'ensemble de points de pression est nulle et l'aire de l'enveloppe convexe formée par l'ensemble de points de support et de pression est non nulle.

3. Procédé selon l'une des revendications 1 et 2, dans lequel le premier substrat (1a) est maintenu par des ventouses (3) placées aux points de support (S1, S2) .

4. Procédé selon la revendication 3, dans lequel chaque ventouse (6) est reliée à un bras télescopique (4) .

5. Procédé selon l'une des revendications 1 et 2, dans lequel les deuxièmes substrats (1b) sont placés sur un support (10) comprenant au moins deux éléments d'espacement (11) respectivement de chaque côté des deuxièmes substrats (1b), lesdits éléments d'espacement étant plus hauts que l'épaisseur des deuxièmes substrats (1b) .

6. Procédé selon la revendication 5, dans lequel le premier substrat (1a) est maintenu en reposant sur les éléments d'espacement (11), les points de support (S1, S2) étant des points de contact entre les éléments d'espacement (11) et le premier substrat.

7. Procédé selon l'une des revendications 5 et 6, dans lequel le support (10) comprend au moins une ventouse (12) maintenant les deuxièmes substrats (1b) .

8. Procédé selon l'une des revendications 1 à 7, dans lequel la contrainte (F) est appliquée par au moins une tige de piston (5).

9. Procédé selon l'une des revendications 1 à 8, dans lequel le premier substrat (1a) est une feuille de verre, et dans lequel les deuxièmes substrats (1b) sont en tuile de silicium.

## Patentansprüche

1. Verfahren zum Verbinden eines ersten Substrats (1a), das eine erste Oberfläche (2a) aufweist, mit einer Vielzahl von zweiten Substraten (1b), die jeweils eine zweite Oberfläche (2b) aufweisen, **dadurch gekennzeichnet, dass** es die folgenden Schritte umfasst:
- Halten des ersten Substrats (1a) durch mindestens zwei Auflagepunkte (S1, S2),
- Positionieren des ersten Substrats (1a) und der zweiten Substrate (1b) derart, dass die erste Oberfläche (2a) und die zweiten Oberflächen (2b) einander gegenüberliegen,
- Verformen des gesamten ersten Substrats (1a) durch Aufbringen zwischen mindestens einem Druckpunkt (P1) und den beiden Auflagepunkten (S1, S2), einer Kraft (F), die in Richtung der zweiten Substrate (1b) gerichtet ist,
- Inkontaktbringen der verformten ersten Oberfläche (2a) und mindestens einer zweiten Oberfläche (2b),
- schrittweises Nachlassen der Kraft (F), wobei das erste Substrat (1a) gleichzeitig mit der Vielzahl von zweiten Substraten (1b) verbunden wird.

2. Verfahren nach Anspruch 1, wobei die Fläche der konvexen Hülle, die durch die Gesamtheit der Druckpunkte gebildet wird, gleich Null ist und die Fläche der konvexen Hülle, die durch die Gesamtheit der Auflagepunkte und Druckpunkte gebildet wird, ungleich Null ist.

3. Verfahren nach einem der Ansprüche 1 und 2, wobei das erste Substrat (1a) durch Sauger (3) gehalten wird, die an den Auflagepunkten (S1, S2) platziert sind.

4. Verfahren nach Anspruch 3, wobei jeder Sauger (6) mit einem Teleskoparm (4) verbunden ist.

5. Verfahren nach einem der Ansprüche 1 und 2, wobei die zweiten Substrate (1b) auf einem Träger (10) angeordnet sind, der mindestens zwei Abstandsstücke (11) jeweils auf jeder Seite der zweiten Substrate (1b) umfasst, wobei die Abstandsstücke höher als die Stärke der zweiten Substrate (1b) sind.

6. Verfahren nach Anspruch 5, wobei das erste Substrat (1a) gehalten wird, indem es auf den Abstandsstücken (11) aufliegt, wobei die Auflagepunkte (S1, S2) Kontaktpunkte zwischen den Abstandsstücken (11) und dem ersten Substrat sind.

7. Verfahren nach einem der Ansprüche 5 und 6, wobei der Träger (10) mindestens einen Sauger (12) umfasst, der die zweiten Substrate (1b) hält.

8. Verfahren nach einem der Ansprüche 1 bis 7, wobei die Kraft (F) durch zumindest eine Kolbenstange (5) aufgebracht wird.

9. Verfahren nach einem der Ansprüche 1 bis 8, wobei das erste Substrat (1a) eine Glasscheibe ist, und wobei die zweiten Substrate (1b) aus Siliziumplatte sind.

## Claims

1. Process for bonding a first substrate (1a) having a first surface (2a) to a plurality of second substrates (1b) each having a second surface (2b), **characterized in that** it comprises the steps consisting in:
- holding the first substrate (1a) by at least two support points (S1, S2),
- positioning the first substrate (1a) and the second substrates (1b) so that the first surface (2a) and the second surfaces (2b) face each other;
- deforming the whole first substrate (1a) by applying, between at least one pressure point (P1) and the two support points (S1, S2), a strain (F) toward the second substrates (1b);
- bringing the deformed first surface (2a) and at least one second surface (2b) into contact; and
- progressively releasing the strain (F), the first substrate (1a) being simultaneously bonded to said plurality of second substrates (1b).

2. Process according to claim 1, wherein the surface area of a convex hull formed by the set of pressure points is null and the surface area of a convex hull formed by the set of support and pressure points is non-null.

3. Process according to one of claims 1 and 2, wherein the first substrate (1a) is held by suckers or suction cups (3) placed at the support points (S1, S2).

4. Process according to claim 3, wherein each sucker or suction cup (6) is linked to a telescopic arm (4).

5. Process according to one of claims 1 and 2, wherein the second substrates (1b) are placed on a support (10) comprising at least two spacers (11) located respectively on each side of the second substrates (1b), said spacers being thicker than the thickness of the second substrates (1b).

6. Process according to claim 5, wherein the first substrate (1a) is held by resting on the spacers (11), the support points (S1, S2) being points of contact between the spacers (11) and the first substrate.

7. Process according to one of claims 5 and 6, wherein the support (10) comprises at least one sucker or suction cup (12) for holding the second substrates (1b).

8. Process according to one of claims 1 to 7, wherein the strain (F) is applied by at least one piston rod (5).

9. Process according to one of claims 1 to 8, wherein the first substrate (1a) is a glass sheet, and wherein the second substrates (1b) are made of silicon tile.
